# DEMANDE DE BREVET EUROPEEN

(11) **EP 1 760 785 A2**
(43) Date de publication de la demande: **07.03.2007**
(21) Numéro de dépôt: 06119929.5
(22) Date de dépôt: 31.08.2006
(51) Int. Cl.: H01L 27/06, H01L 27/08

(54) **Circuit d'allumage**

(30) Priorité: 31.08.2005 FR 0552616
(71) Demandeur: ST MICROELECTRONICS S.A., 92120 Montrouge (FR)
(72) Inventeur: Menard, Samuel, 37000, Tours (FR); Cheron, Benjamin, 37540, Saint Cyr Sur Loire (FR); Edet, Arnaud, 37000, Tours (FR)
(74) Mandataire: de Beaumont, Michel

(57) **Abrégé**

L'invention concerne un composant réalisé dans un substrat (1) d'un premier type de conductivité, comportant deux entrées (E, REF) et deux sorties (A, K) et :
une première diode (D2) dont l'anode est connectée à une première entrée (E), sa cathode étant connectée à une première sortie (A) ;
une deuxième diode (D1) dont l'anode est connectée à une seconde sortie (K), sa cathode étant connectée à la première entrée ;
un commutateur unidirectionnel (Th) dont l'anode est connectée à la première sortie, sa cathode étant connectée à la seconde sortie ; et
une troisième diode (D3) dont l'anode est connectée à la seconde sortie, sa cathode étant connectée à la première sortie ;
les première, deuxième et troisième diodes étant réalisées dans une première partie du substrat séparée par un mur (2) du second type de conductivité d'une seconde partie du substrat comportant le commutateur.

## Description

### Domaine de l'invention

La présente invention concerne le domaine des circuits d'alimentation intégrés. Plus particulièrement, la présente invention concerne l'intégration d'un composant faisant partie du circuit d'allumage d'un moteur deux temps.

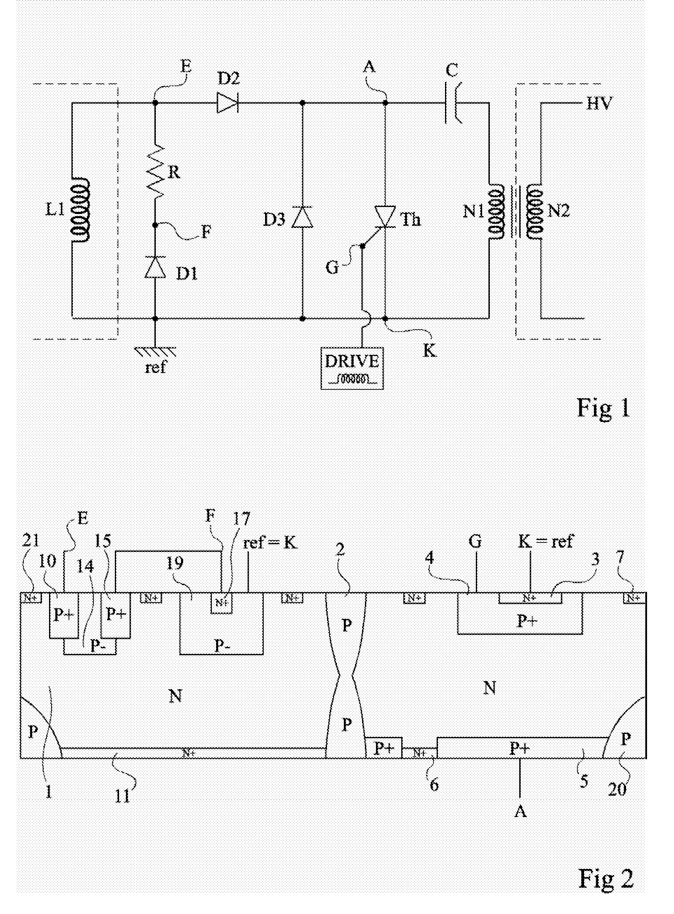

La figure 1 est un schéma électrique équivalent partiel et schématique d'un circuit d'allumage d'un moteur deux temps.

Le circuit comporte, entre deux bornes d'entrée E et REF, un enroulement inductif L1 excité périodiquement par le passage d'un aimant non représenté disposé sur une roue qui est lancée avec le vilebrequin quand on veut faire démarrer le moteur.

Une borne A est reliée à une première armature positive d'un condensateur C. Une seconde armature négative du condensateur C est reliée à une borne K par l'intermédiaire d'un enroulement primaire N1 d'un circuit magnétique dont un enroulement secondaire N2 fournit une haute tension à un circuit d'allumage d'un moteur deux temps dont la structure n'est pas détaillée ici.

Les bornes REF et K sont interconnectées et correspondent à une borne de référence basse du circuit.

Entre la borne E et la borne A, le circuit comporte une diode D2 propre à ne laisser passer le courant que de la borne E vers la borne A.

Un commutateur unidirectionnel, normalement ouvert, commandable à la fermeture est connecté entre la borne A et la borne K. Par exemple, le commutateur normalement ouvert est un thyristor Th dont la cathode est reliée à la borne K. La gâchette G est reliée à un circuit de commande DRIVE propre à délivrer un signal de commande de fermeture.

Une diode de roue libre D3 est connectée entre les bornes A et K en anti-parallèle par rapport au thyristor Th.

Une diode D1 est connectée entre les bornes E et REF, son anode étant reliée à la borne REF. La cathode F de la diode D1 est reliée à la borne E par l'intermédiaire d'une résistance R.

Le fonctionnement du circuit de la figure 1 est le suivant.

Lors d'un passage de l'aimant à proximité de l'enroulement L1, la variation de flux magnétique provoque l'apparition d'une impulsion de courant. Le sens de déplacement de l'aimant et le sens d'enroulement de la bobine L1 est tel que l'impulsion charge le condensateur C à travers la diode D2. La diode D1 et la résistance R servent à absorber un éventuel courant négatif entre les bornes E et Ref.

Le condensateur C et l'enroulement L1 sont dimensionnés de façon qu'un seul passage de l'aimant à proximité de l'enroulement L1 induise une impulsion de courant suffisante pour charger le condensateur C à un niveau de tension maximal requis.

L'aimant passe également devant un enroulement non représenté constituant l'alimentation du circuit de commande DRIVE du thyristor Th. L'emplacement et les dimensions de cet enroulement sont tels que le thyristor Th est commandé à la fermeture alors que le condensateur C a atteint le niveau de tension maximal.

Alors, le condensateur C se décharge dans le circuit constitué par le condensateur C, l'enroulement primaire N1 et le trajet de conduction du thyristor Th. Ce circuit est un circuit oscillant et les alternances négatives passent par la diode de roue libre D3. Il en résulte l'apparition d'une haute tension aux bornes de l'enroulement secondaire N2.

La présente invention vise à proposer la réalisation de la partie de ce circuit d'allumage de moteur deux temps comprise entre les bornes E, A, K et G sous forme d'un circuit semiconducteur monolithique.

### Résumé de l'invention

Pour atteindre cet objet, la présente invention prévoit un composant réalisé dans un substrat semiconducteur d'un premier type de conductivité, comportant deux bornes d'entrée et deux bornes de sortie et comprenant :
une première diode dont l'anode est connectée à une première borne d'entrée et dont la cathode est connectée à une première borne de sortie ;
une deuxième diode dont l'anode est connectée à une seconde borne de sortie et dont la cathode est connectée à la première borne d'entrée ;
un commutateur unidirectionnel normalement ouvert commandable à la fermeture dont l'anode est connectée à la première borne de sortie et dont la cathode est connectée à la seconde borne de sortie ; et
une troisième diode dont l'anode est connectée à la seconde borne de sortie et dont la cathode est connectée à la première borne de sortie ;
les première, deuxième et troisième diodes étant réalisées dans une première partie du substrat et le commutateur dans une seconde partie du substrat séparée de la première partie par un mur du second type de conductivité traversant toute l'épaisseur du substrat.

Selon un mode de réalisation de la présente invention, la deuxième diode est réalisée sous forme horizontale et les première et troisième diodes et le commutateur sont réalisés sous forme verticale.

Selon un mode de réalisation de la présente invention, le commutateur est un thyristor à gâchette de cathode.

Selon un mode de réalisation de la présente invention, la première diode est constituée d'une jonction formée en face avant entre une première région de surface fortement dopée du second type de conductivité et le substrat.

Selon un mode de réalisation de la présente invention, le contact avec le substrat est pris par une deuxième région de surface fortement dopée du premier type de conductivité formée en face arrière dans toute la première partie.

Selon un mode de réalisation de la présente invention, le composant comporte, en face avant dans la première partie, une troisième région de surface fortement dopée du premier type de conductivité formée dans une quatrième région de surface faiblement dopée du second type de conductivité.

Selon un mode de réalisation de la présente invention, une résistance est interposée entre la cathode de la deuxième diode et la première borne d'entrée.

Selon un mode de réalisation de la présente invention, le composant comporte en face avant à proximité de la première région une cinquième région fortement dopée du second type de conductivité, une sixième région faiblement dopée du second type de conductivité s'étendant entre les première et cinquième régions.

Selon un mode de réalisation de la présente invention, la seconde partie du substrat comporte en face avant une septième région fortement dopée du premier type de conductivité formée dans une huitième région fortement dopée du second type de conductivité et dont la face arrière comporte au moins une neuvième région fortement dopée du second type de conductivité.

La présente invention prévoit également un circuit d'allumage d'un moteur deux temps, comportant un composant selon l'un quelconque des modes de réalisation précédents.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma électrique équivalent partiel et schématique d'un circuit d'allumage de moteur deux temps ;
la figure 2 illustre, en vue en coupe partielle et schématique, un mode de réalisation sous forme intégrée selon la présente invention d'une partie du circuit de la figure 1 ;
la figure 3 illustre, en vue de dessus partielle et schématique, un autre mode de réalisation sous forme intégrée de la présente invention de la même partie du circuit de la figure 1 ; et
la figure 4 illustre, en vue de dessous partielle et schématique, un mode de réalisation sous forme intégrée de la présente invention de la même partie du circuit de la figure 1.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

La figure 2 illustre, en vue en coupe partielle et schématique, le circuit comprenant les bornes principales E, A, REF-K, et la borne de commande G de la figure 1. Ce circuit intègre la résistance R, les diodes D1, D2, D3 et le thyristor Th. Ce circuit est réalisé dans un substrat semiconducteur, par exemple de silicium monocristallin. Le substrat 1 est moyennement dopé d'un premier type de conductivité, par exemple N.

Le substrat 1 est divisé en deux parties par un mur 2 dopé de type P traversant toute l'épaisseur du substrat 1.

Une première partie du substrat 1, à droite de la figure 2, contient le commutateur unidirectionnel Th normalement ouvert, commandable à la fermeture de la figure 1, par exemple un thyristor Th à gâchette de cathode réalisé sous forme verticale. Du côté d'une première face ou face avant du substrat 1, est formée une région 3 fortement dopée de type N destinée à constituer la cathode du thyristor Th. La région 3 est formée dans un caisson 4 fortement dopé de type P. La région 3 est complètement formée dans une partie de la surface de la région 4 et n'est pas en contact direct avec le substrat 1. La région 3 est solidaire d'une métallisation destinée à constituer la borne K ou REF du circuit. La région 4 est solidaire d'une métallisation destinée à constituer la gâchette G du thyristor Th.

En face arrière, se trouve une région 5 fortement dopée de type P destinée à constituer l'anode du thyristor Th. La région d'anode 5 est interrompue par une région 6 fortement dopée de type N. La région 6 est formée en dehors de l'aplomb de la région 3 et à proximité ou en dessous de la région 4. La région 6 est destinée à assurer une évacuation des charges capacitives (dV/dt) s'accumulant dans le substrat 1 pour éviter une fermeture du thyristor Th quand il doit tenir en inverse la tension surélevée aux bornes du condensateur C.

La face arrière est solidaire d'une métallisation destinée à constituer la borne A du circuit.

De préférence, la face avant comporte également une région annulaire 7 fortement dopée de type N autour de la région 4 et distincte de celle-ci, destinée à constituer un anneau de garde pour bloquer d'éventuels courants de fuite.

Une deuxième partie du substrat 1, à gauche de la figure 2, comporte l'ensemble des commutateurs unidirectionnels commandés en tension, par exemple les diodes D1, D2 et D3, ainsi que la résistance R de limitation du courant.

La diode D2 est formée verticalement entre le substrat 1 de type N et une région d'anode (P⁺) 10 formée à la surface de la face avant du substrat 1. Le contact de cathode est assuré en face arrière par une région (N⁺) 11 fortement dopée de type N. La région 10 est solidaire d'une métallisation destinée à constituer la borne E du quadripôle. La région 11 est solidaire de la métallisation de face arrière constituant la borne A du circuit.

La région 10 est connectée par l'intermédiaire d'un caisson (P⁻) 14 faiblement dopé de type P associé à une région (P⁺) 15 fortement dopée de type P à une métallisation.

Une région (N⁺) 17 fortement dopée de type N est formée dans un caisson (P⁻) 19 faiblement dopé de type P. La région 17 est reliée par une métallisation à la région 15. Le caisson 19 est relié par une métallisation à la borne REF-K également reliée à la région 3.

On forme ainsi latéralement la diode D1 entre la région 17 et la région 19. L'ensemble 15-14-10 constitue la résistance R placée entre les bornes E et F de la figure 1 c'est-à-dire entre la région 17 de cathode de la diode D1 et la région 10 d'anode de la diode D2.

La diode D1 peut avantageusement être formée latéralement car la chute de tension aux bornes de la diode D1 est au plus la tension d'alimentation E-REF. Cette diode D1 aura une tension de claquage en inverse qui sera essentiellement déterminée par le dopage de la région 19 qui peut être relativement faible. Par contre, la diode D2 est formée verticalement car la tension à ses bornes atteint la tension surélevée aux bornes du condensateur C.

La diode D3 est également réalisée verticalement car elle doit également pouvoir supporter la tension surélevée aux bornes du condensateur C. Selon un mode de réalisation de la présente invention, la diode D3 est avantageusement constituée par la jonction existant entre la région 19 d'anode de la diode D1 et la région 11 de cathode de la diode D2.

La surface du substrat 1 comporte un anneau de garde 21 qui entoure la partie du substrat comportant les régions 10, 14 et 15 - c'est-à-dire la diode D2 et la résistance R - et la partie du substrat comportant les régions 17 et 19 - c'est-à-dire la diode D1 et la diode D3.

On notera que la diode D3 étant réalisée dans une partie du substrat 1 distincte de la partie dans laquelle est formé le thyristor Th, le compromis entre la sensibilité de déclenchement du thyristor Th et la tenue au bruit capacitif dV/dt est facilement ajustable.

Le mur 2 séparant la partie du substrat 1 dans laquelle est formée la diode D2 de sa partie dans laquelle est formé le thyristor Th, la circulation et l'accumulation de charges lors de la charge du condensateur C à travers la diode D2 ne risquent pas de provoquer un court-circuit par déclenchement parasite du thyristor Th.

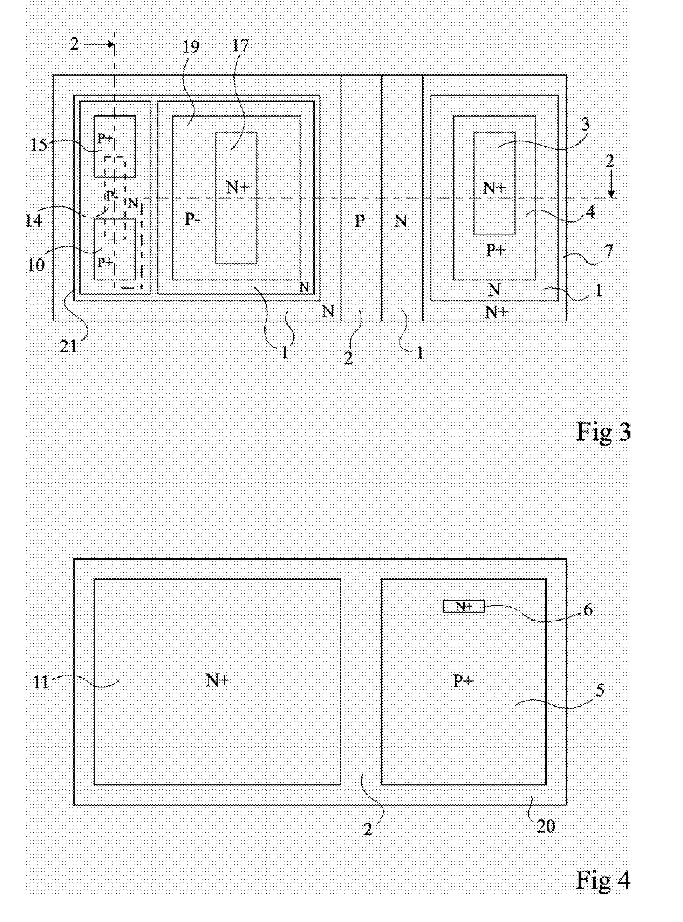

La figure 3 illustre en vue de dessus partielle et schématique un exemple de topologie de la face avant du composant de la figure 2. L'axe 2-2 en traits pointillés correspond à l'axe de coupe selon lequel est tracé la figure 2. Le composant comporte deux parties séparées par le mur 2. Dans la partie de gauche sont formées deux zones délimitées par l'anneau de garde 21. Une première zone comporte les régions 10 et 15 et, à l'intérieur du caisson 19, une seconde zone la région 17. Dans la partie de droite, l'anneau 7 délimite une zone du substrat 1 comportant la région 3 formée dans la région 4.

La figure 4 illustre schématiquement et partiellement un mode de réalisation de la face arrière du composant de la figure 2. La périphérie de la face arrière comporte un caisson 20 - déjà représenté en figure 2 - du même type de conductivité P que le mur 2 et destiné à protéger le composant des possibles courts-circuits liés à des coulages de brasure. Le mur 2 sépare la face arrière en deux parties. A droite de la figure 4, le mur 2 et le caisson 20 délimitent la région 11. A gauche de la figure 4, la face arrière comporte la région 6 incluse dans la région 5.

Selon un mode de réalisation de la présente invention, les niveaux de dopage des différentes régions de la figure 2 sont les suivants :
- régions 14 et 19 dopées de type P de 5.10¹⁴ à 5.10¹⁵ at/cm³, par exemple de l'ordre de 10¹⁵ at/cm³ ;
- région 2 dopée de type P de 10¹⁶ à 10¹⁷ at/cm³, par exemple de l'ordre de 5.10¹⁷ at/cm³ ;
- régions 10, 5 et 4 dopées de type P : de 10¹⁷ à 10¹⁹ at/cm³, par exemple de l'ordre de 10¹⁸ at/cm³ ;
- substrat 1 dopé de type N de 10¹⁴ à 10¹⁵ at/cm³, de préférence de l'ordre de 10¹⁴ at/cm³ ;
- région 17 dopée de type N de l'ordre de 10¹⁵ à 10¹⁷ at/cm³, par exemple d'environ 10¹⁶ at/cm³ ;
- régions 3, 6, 7, 21 dopées de type N de l'ordre de 10¹⁹ à 10²¹ at/cm³, par exemple d'environ 10²⁰ at/cm³.

Bien entendu, la présente invention est susceptible de diverses variantes et modifications qui apparaîtront à l'homme de l'art. En particulier, l'homme de l'art comprendra que le circuit de la figure 1 peut également utiliser un thyristor normalement fermé à commande d'ouverture par une gâchette d'anode. Alors, tous les types de conductivité de la figure 2 sont inversés.

L'homme de l'art comprendra que seuls les éléments nécessaires à la compréhension de la présente invention ont été illustrés et décrits précédemment. Ainsi, l'homme de l'art comprendra comment compléter la structure pour obtenir le circuit de la figure 1. En particulier, l'homme de l'art saura réaliser les différentes métallisations d'interconnexion nécessaires. De même, la structure du circuit de commande DRIVE susceptible d'être intégrée séparément n'est pas détaillée ici.

En outre, le composant selon la présente invention a été décrit dans le cadre d'un circuit d'allumage d'un moteur deux temps. Toutefois, un tel composant est susceptible d'être utilisé dans d'autres types de circuit.

## Revendications

1. Composant réalisé dans un substrat semiconducteur (1) d'un premier type de conductivité (N), comportant deux bornes d'entrée (E, REF) et deux bornes de sortie (A, K) et comprenant :
une première diode (D2) dont l'anode est connectée à une première borne d'entrée (E) et dont la cathode est connectée à une première borne de sortie (A) ;
une deuxième diode (D1) dont l'anode est connectée à une seconde borne de sortie (K) et dont la cathode est connectée à la première borne d'entrée ;
un commutateur unidirectionnel normalement ouvert commandable à la fermeture (Th) dont l'anode est connectée à la première borne de sortie et dont la cathode est connectée à la seconde borne de sortie ; et
une troisième diode (D3) dont l'anode est connectée à la seconde borne de sortie et dont la cathode est connectée à la première borne de sortie ;
dans lequel les première, deuxième et troisième diodes sont réalisées dans une première partie du substrat et le commutateur dans une seconde partie du substrat séparée de la première partie par un mur (2) du second type de conductivité (P) traversant toute l'épaisseur du substrat et dans lequel la deuxième diode est réalisée sous forme horizontale et les première et troisième diodes et le commutateur sont réalisés sous forme verticale.

2. Composant selon la revendication 1, dans lequel le commutateur (Th) est un thyristor à gâchette de cathode.

3. Composant selon la revendication 2, dans lequel la première diode (D2) est constituée d'une jonction formée en face avant entre une première région de surface (10) fortement dopée du second type de conductivité (P⁺) et le substrat (1).

4. Composant selon la revendication 3, dans lequel le contact avec le substrat (1) est pris par une deuxième région de surface fortement dopée du premier type de conductivité (N⁺) formée en face arrière dans toute la première partie.

5. Composant selon la revendication 3 ou 4, comportant en face avant dans la première partie une troisième région de surface (17) fortement dopée du premier type de conductivité (N⁺) formée dans une quatrième région de surface (19) faiblement dopée du second type de conductivité (P⁻).

6. Composant selon la revendication 1, dans lequel une résistance (R) est interposée entre la cathode de la deuxième diode (D1) et la première borne d'entrée (E).

7. Composant selon les revendications 6 et 3 ou 6 et 4 ou 6 et 5, comportant en face avant à proximité de la première région (10) une cinquième région (15) fortement dopée du second type de conductivité (P⁺), une sixième région (14) faiblement dopée du second type de conductivité (P⁻) s'étendant entre les première et cinquième région.

8. Composant selon l'une quelconque des revendications 2 à 6, dans lequel la seconde partie du substrat comporte en face avant une septième région (3) fortement dopée du premier type de conductivité (N⁺) formée dans une huitième région (4) fortement dopée du second type de conductivité (P⁺) et dont la face arrière comporte au moins une neuvième région (5) fortement dopée du second type de conductivité (P⁺).

9. Circuit d'allumage d'un moteur deux temps, comportant un composant selon l'une quelconque des revendications 1 à 8.
